(19) Europäisches Patentamt
European Patent Office
Office européen des brevets

(11) Publication number: **0 286 829 A2**

(12) **EUROPEAN PATENT APPLICATION**

(21) Application number: **88103647.9**

(22) Date of filing: **08.03.88**

(51) Int. Cl.4: **H01L 21/312 , H01L 23/52 , H05K 1/03 , H01B 3/30 , H01F 10/30 , G11B 5/702 , H01L 23/28**

The title of the invention has been amended (Guidelines for Examination in the EPO, A-III, 7.3).

(30) Priority: **11.03.87 JP 54032/87**

(43) Date of publication of application: **19.10.88 Bulletin 88/42**

(84) Designated Contracting States: **CH DE FR GB IT LI NL SE**

(71) Applicant: **HITACHI, LTD.**
**6, Kanda Surugadai 4-chome Chiyoda-ku**
**Tokyo 100(JP)**

(72) Inventor: **Miwa, Takao**
**19-4-402, Ishinazakacho-1-chome**
**Hitachi-shi(JP)**
Inventor: **Numata, Shunichi**
**1-15, Miyatacho-3-chome**
**Hitachi-shi(JP)**
Inventor: **Fujisaki, Koji**
**26-19, Higashionumacho-2-chome**
**Hitachi-shi(JP)**
Inventor: **Ikeda, Takayoshi**
**1161-3, Ishigamiuchijuku Tokaimura**
**Naka-gun Ibaraki-ken(JP)**
Inventor: **Kinjo, Noriyuki**
**19-1, Kanesawacho-7-chome**
**Hitachi-shi(JP)**

(74) Representative: **Strehl, Schübel-Hopf, Groening, Schulz**
**Widenmayerstrasse 17 Postfach 22 14 55**
**D-8000 München 22(DE)**

(54) **Electronic device comprising a polyimide layer, and method for its production.**

(57) An electronic device having a polyimide layer (7) which is in direct or indirect contact with at least one active area (6) of the electronic device, wherein the polyimide has, at one end of the molecule, a carboxy group attached to an aliphatic carbon atom.

The polyimide layer (7) of the electronic device consists of a homogeneous insulating film improved in flatness and adhesive properties without imparing the heat resistant, mechanical properties, and electrical properties inherent in polyimides, whereby it has been possible to provide the electronic device improved in reliability and performance.

FIG. 2

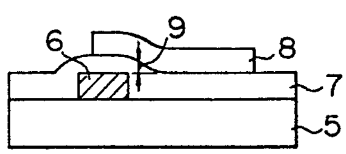


EP 0 286 829 A2

Xerox Copy Centre

# ELECTRONIC DEVICE AND METHOD FOR PRODUCTION THEREOF

## BACKGROUND OF THE INVENTION

The present invention relates to electronic devices and particularly, it is concerned with electronic devices having interlaminar insulating films which exhibit high flatness and superior adhesive properties and with a method for producing such electronic devices.

As the performance improvement and miniaturization of electronic devices have been advances, these devices have been rapidly growing finer and more complicate in structure. Especially, it has become an important subject to establish a technique which can ensure insulations between a substrate and a wiring between wirings, and moreover between a magnetic part and a wiring.

For example, the technique of multilayer wiring has become indispensable to LSI's. Interlaminar insulation films in multilayer circuit devices are required to have insulation resistance sufficient to secure the insulation between wirings supported severally by two layers lying one over another. These insulation films are also required to have such high flatness as not to cause any fatal obstacle, such as notable level difference or break, to the productivity or reliability when the next layer wiring is fabricated. Moreover, the insulating films are asked to exhibit superior adhesion to substrates, wirings, or other insulating films in view of the moisture resistance, durability, and reliability of the product multilayer circuit devices.

While interlaminar insulating films are investigated in both the aspects of organic and inorganic materials, organic materials are advantageous in film flatness. A typical example of the interlaminar organic insulating films heretofore disclosed is formed from PIQ of Hitachi Chemical Co., Ltd. PIQ is a varnish which provides a polyimide resin on thermal curing or chemical treatment. The resulting insulating films are excellent in heat resistance and mechanical properties. When used for LSI devices, PIQ is applied on wafers by a suitable method such as spin coating and then subjected to heat treatment or some other treatment, providing intended interlaminar insulating films. The obtained films are superior in flatness to inorganic insulating film formed by CVD or the like. Nevertheless, a further improvement of the flatness has been required, as LSI's have become more highly integrated and accordingly have become finer in structure and higher in wiring aspect ratio. Thus, the flatness has been an important problem in LSI production processes.

The flatness of these insulating films can be improved by increasing the content of solids in the varnish. However, as the solid content is increased, the viscosity increases remarkably spoiling the workability. To overcome this difficulty, there has been taken the measure of employing oligoamic acid that is a polyamic acid of extremely low molecular weights or the measure of utilizing a soluble imide oligomer or isoimide oligomer. Thereby, increase in the concentration with workability has become possible. The above measures are contemplated to convert said oligomers, which retain the molecular weight thereof as such during coating operation, e.g. spin coating, into macromolecular polymers by treatment such as heating to react active terminal groups of the oligomers, thereby providing excellent insulating films. Reactive terminal groups hitherto investigated include half-esterified acid anhydride groups, ethynyl group, vinyl group, and biphenyl group. For example, Japanese Patent Application Laid-Open No. 120723 proposes an electronic device comprising an insulating film(s) formed from a polymerizable oligomer having a vinyl group or an ethynyl group at an end of the molecule, by curing to polymerize. Any of these insulating films, however, is not comparable in insulating film characteristics to that of the present invention.

Corrosion of LSI affecting largely the reliability thereof is regarded as attributable chiefly to moisture condensation on stripped areas of LSI. Accordingly, the insulating film is required to exhibit sufficient bond strength to substrates, wirings, and further to other insulating films. The bond strength has great influence on the reliability of product and hence is an important matter. Needless to say, the adhesive property has great significance also to the production process. It is known that the adhesion between two materials is much due to polar groups present in their molecules. Therefore, the adhesive property of polyimide has been improved up to now by copolymerizing 1,3-bis($\gamma$-aminopropyl)tetramethyldisiloxane or the like having polar groups. But, the resulting film is not comparable in adhesive properties to that of the present invention.

It is desired for a plurality of materials forming a composite to have nearly the same coefficient of thermal expansion. In particular, it is important for LSI devices to be composed of materials which have nearly the same coefficient of thermal expansion, since LSI devices are compricate combinations of fine members, which are additionally exposed to high temperatures in the fabrication process and their

mounting operations. Organic compounds generally have thermal expansion coefficients of about $5 \times 10^{-5}$, which are 10 times and more those of inorganic compounds. Thus, there is great difference in the coefficient of thermal expansion between these groups of compounds. However, insulating films having an exceptionally low coefficient of thermal expansion equivalent to those of inorganic compounds can be formed from PIQ-L100 of Hitachi Chemical Co., Ltd. But, with respect to flatness, insulating films from PIQ-L100 are similar to those from conventional PIQ and hence dissimilar to the insulating film of the present invention.

While the above description takes LSI as an example, the same discussion holds for an insulating film laid between a conductor and a Permalloy member in a magnetic bubble device, an insulating film laid between wirings in a high-density circuit board, an interlaminar insulating film laid between a conductor coil and an upper magnetic member in a thin-film magnetic head, and a flattened insulating film laid on a solar battery substrate.

Binders used today for the magnetic members of magnetic disks are made of epoxy-phenol resins. The thermal expansion coefficient of these epoxy-phenol resins is of the same order as those of common organic substances. When it is intended to use PIQ-L100 in a concentration of the same order, viz some dozen % by weight, as those of currently used binders, the viscosity of PIQ-L100 in such a concentration is too high and the workability thereof is therefore markedly worse.

Varnishes are now used for various electronic devices in their fabrication processes. Such electronic devices include $\alpha$-ray shield films, flexible print substrates and semiconductor passivation films, besides the above-mentioned LSI's, thin-film magnetic heads, magnetic bubble devices, etc., wherein the flatness of films formed from varnishes is regarded as an important matter. Concentrations of varnishes used for the fabrication of these devices are generally as low as some dozen % by weight. As stated above, this is because there has been no varnish that can be applied in high concentrations and on curing, provides films having satisfactory properties.

Insulating films formed from all polyamic acid above-mentioned polyamic acid varnish cannot satisfy the required flatness and hence have the matter when applied to electronic devices. In the case of thin-film magnetic heads, it is required in connection with the performance that the roughness of the insulating film which insulates a coil from another coil and the coils from an upper magnetic member should not exceed 0.2 m$\mu$ on the film-magnetic member interface. Even when a low-concentration polyamic acid varnish is used, the above flatness requirement can be satisfied by applying a thick coat of the varnish. However, such a thick coat of varnish is undesirable with respect to the performance since the coat results in an increased distance between the coil and the upper magnetic member. Therefore, the desired end is achieved for the present by etching the flattened surface of such thick coats to reduce the thickness. The etching rate at present is not necessarily stable and is not even-throughout the coat, in either the dry process or the wet process. It has become a significant problem to involve such an etching step in the fabrication process. In the case of magnetic bubble devices, the level difference between the conductor pattern and its supporting layer, if transferred as such on the Permalloy pattern, will result in unnecessary magnetic poles at the level difference portion of the Permalloy pattern and these magnetic poles will have adverse effect on the transmission of bubbles. Therefore, the level difference has been decreased by using a polyamic acid such as PIQ. However, as higher-density devices are developed, the reduction of the level difference is demanded more strongly and it has become impossible to meet this demand by using the conventional polyamic acid type varnish. Thus, devices provided with insulating films formed from the existing polyamic acid have significant problems in both the aspect of process and performance. This is also true in the case of insulating films of LSI and those of electronic devices such as solar batteries.

When the above-mentioned oligomer having a reactive terminal group is used, the flatness is improved to a large extent but problems arise in mechanical and thermal properties of the formed film. In the case of an oligoamic acid having a terminal group of half-exterified acid anhydride, an imide is produced by heat treatment, but this imide has a low molecular weight and is hence brittle. When an imide or isoimide oligomer having a vinyl or thynyl terminal group is used, the cured polymer has markedly inferior mechanical properties and additionally contains thermally-unstable groups such as unreacted vinyl groups and alkyl carbon-carbon single bonds.

Adhesion of each parts is important for electronic devices of composite structure, such as LSI's and high-density circuit boards. However, polyimide resin in use today are not necessarily sufficient in adhesive properties, hence detracting the moisture-proof reliability of products. This is conceivably because the polyimide skeleton has a strong cohesive force and contains no hydroxy or carboxy group in a state capable of forming a hydrogen bond with other substances. For improving the adhesive property, a polar group-containing monomer such as 1,3-bis($\gamma$-aminopropyl)-tetramethylsiloxane has been copolymerized up

to now. According to this method, however, a thermally and chemically unstable alkyl carbon-carbon single bond or carbon-oxygen single bond will be introduced in the main chain. Accordingly, the scission of main chains is liable to take place. Thus, this method impairs the heat resistance and the chemical resistance which are characteristics of polyimides.

## SUMMARY OF THE INVENTION

It is the first object of the invention to provide electronic devices having interlaminar insulating films which are excellent in heat resistance chemical resistance and mechanical properties as well as in flatness and adhesive properties.

It is the second object of the invention to provide a process for producing electronic devices having interlaminar insulating films which are excellent in heat resistance, chemical resistance and mechanical properties as well as in flatness and adhesive properties.

Other objects of the invention will be apparent from the following parts of the present specification.

## BRIEF DESCRIPTION OF THE DRAWINGS

Fig. 1 is a cross-sectional view of a multilayer wiring structure of LSI.

Fig. 2 is a cross-sectional view of a magnetic bubble memory device.

Fig. 3 is a cross-sectional view of a thin-film magnetic head.

Fig.4 is a cross-sectional view of a high-density circuit board.

Fig. 5 is a schematic view of a pattern used for evaluation. Fig. 6 is a cross-sectional view of a formed specimen.

## DETAILED DESCRIPTION OF PREFERRED EMBODIMENTS

The above objects can be achieved by constructing an electronic device in which a polyimide resin having a carboxy group attached to an aliphatic carbon atom, at parts of the end of the molecule is in direct or indirect contact with at least one active area of the electronic device.

In the present invention, "Active area of an electronic device" is as follows. That is, "in an electronic device, the area which

1. makes an electric current form,
2. forms electrons or positive holes, and
3. through which electrons or positive holes pass."

For example,

gate, source, drain and wiring in LSI,

coil, magnetic body and wiring in a magnetic head, and conductor, permalloy, in a bubble memory etc., correspond to it.

The first feature of the invention is that, in an electronic device having a polyimide layer which is in direct or indirect contact with at least one active area of the electronic device, the main chain of the polyimide is constituted of all or some of the residues:

(1) 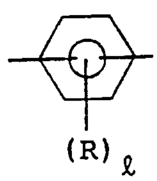 , (2) 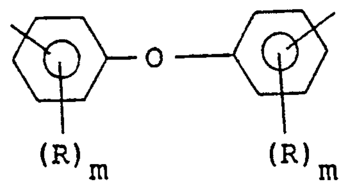 , (3) 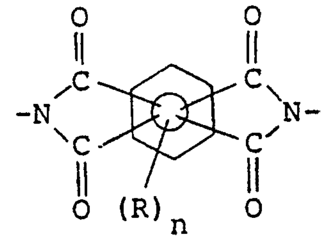 ,

(4) 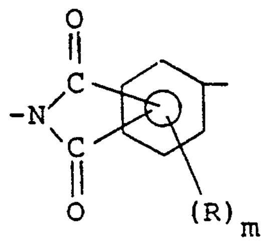 , (5) 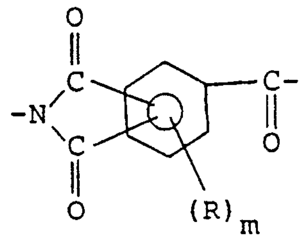

(wherein, R is selected from the group consisting of alkyl, fluorinated alkyl, alkoxy, fluorinated alkoxy, acyl, and halogen, ℓ is an integer of 0 to 4, m is an integer of 0 to 3 and n is an integer of 0 to 2, and the polyimide has, at one end of the molecule, a carboxy group attached to an aliphatic carbon atom.

The second feature of the invention is that in an electronic device having an insulating layer formed of a polyimide between conductors or semiconductors, the main chain of the polyimide is constituted of all or some of the residues of the above formulae (1) to (5), the polyimide has, at one end of the molecule, a carboxy group attached to an aliphatic carbon atom, and the insulating layer is formed between a silicon wafer and a wiring or between wirings.

The third feature of the invention is that in a thin-film magnetic head having an insulating layer between a substrate and a wiring or between wirings, the insulating layer is formed of a polyimide, the main chain of the polyimide is constituted of all or some of the residues of the above formulae (1) to (5), and the polyimide has, at one end of the molecule, a carboxy group attached to an aliphatic carbon atom.

The forth feature of the invention is that in a high-density circuit board having an insulating layer between a substrate and a wiring or between wirings, the insulating layer is formed of a polyimide, the main chain of the polyimide is constituted of all or some of the residue of the above formulae (1) to (5), and the polyimide has, at one end of the molecule, a carboxy group attached to an aliphatic carbon atom.

The fifth feature of the invention is that in a magnetic bubble memory having an insulating layer between a substrate and a wiring or between wirings, the insulating layer is formed of a polyimide, the main chain of the polyimide is constituted of all or some of the residues of the above formulae (1) to (5), and the polyimide has, at one end of the molecule, a carboxy group attached to an aliphatic carbon atom.

The sixth feature of the invention is that in a magnetic disk comprising a magnetic material-containing insulating layer formed on a nonmagnetic substrate, the insulating layer is formed of a polyimide, the main chain of the polyimide is constituted of all or some of the residues of the above formulae (1) to (5), and the polyimide has, at one end of the molecule, a carboxy group attached to an aliphatic carbon atom.

The seventh feature of the invention is that in a solar battery comprising a substrate coated with an insulating layer, the insulating layer is formed of a polyimide, the main chain of the polyimide is constituted of all or some of the residues of the above formulae (1) to (5), and the polyimide has, at one end of the molecule, a carboxy group attached to an aliphatic carbon atom.

The eighth feature of the invention is that in a memory device having an insulating layer as an α-ray shield film between conductors or semiconductors, the insulating layer is formed of a polyimide, the main chain of the polyimide is constituted of all or some of the residues of the above formulae (1) to (5), and the polyimide has, at one end of the molecule, a carboxy group attached to an aliphatic carbon atom.

The nineth feature of the invention is that in an electronic device having a polyimide layer being in direct or indirect contact with at least one active area of the electronic device, the polyimide layer is formed of a product of reacting the following compounds I and II:

I:

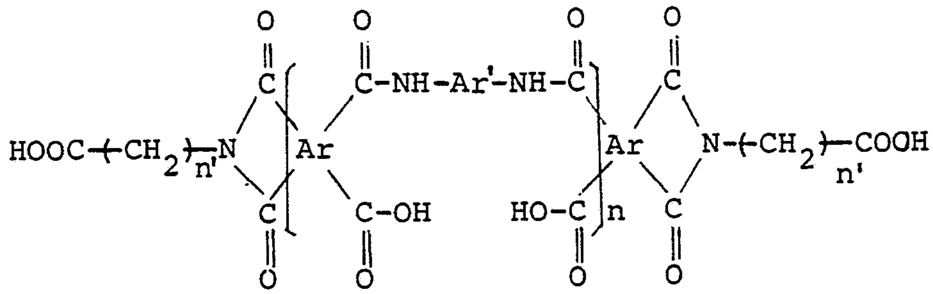

II:

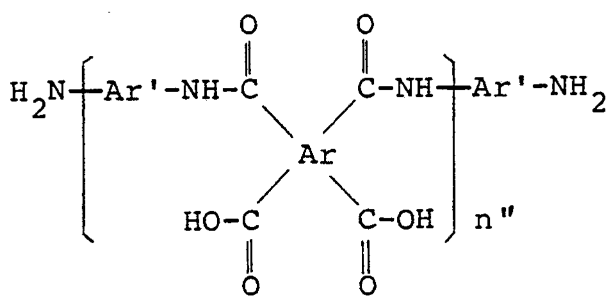

with each other, where the n of compound I and the n″ of compound II are each an integer of 0 to 10, the n′ of compound I is an integer of 2 to 12, and Ar and Ar′ are aromatic residues. One end of the molecule of compound I need not take imido structure and may take acid anhydride structure.

The tenth feature of the invention is that in compounds I and II, Ar is selected from the following residues.

III: 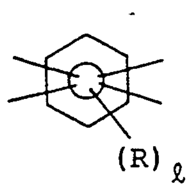 ,

IV: 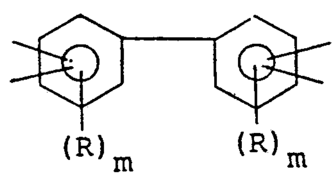 ,

V: 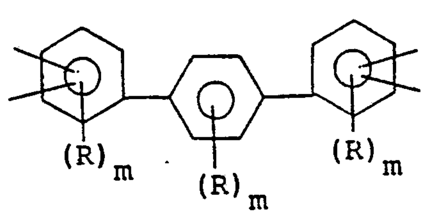 ,

VI: 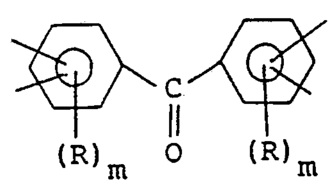 ,

and Ar′ is selected from the following residues:

VII: VIII: IX:

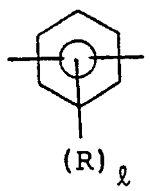 , 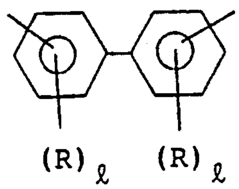 , 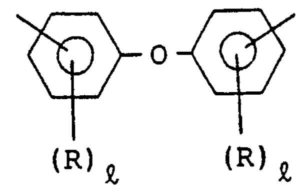

(in residues III to IX, R is selected from the group consisting of alkyl, fluorinated alkyl, alkoxy, fluorinated alkoxy, acyl, and halogen, ℓ in residue III is an integer of 0 to 2 and ℓ in residues VII, VIII and IX is an integer of 0 to 4, m is an integer of 0 to 3, and n is an integer of 0 to 4).

Suitable aromatic diamines for use in the invention include, for example, p-phenylene-diamine, 2,5-diaminotoluene, 2,5-diaminoxylene, diaminodurene (2,3,5,6-tetramethyl-p-phenylenediamine), 2,5-diaminobenzene trifluoride, 2,5-diaminoanisole, 2,5-diaminoacetophenone, 2,5-diaminobenzophenone, 2,5-diaminodiphenyl, 2,5-diaminofluorobenzene, benzidine, o-tolidine, m-tolidine, 3,3′,5,5′-tetramethylbenzidine, 3,3′-dimethoxybenzidine, 3,3′-di(trifluoromethyl)-benzidine, 3,3′-diacetylbenzidine, 3,3′-difluorobenzidine, octafluorobenzidine, 4,4″-diaminoterphenyl, and 4,4″-diaminoquaterphenyl.

Suitable tetracarboxylic cianhydride derivatives for use in the invention include, for example, pyromellitic dianhydride, methylpyromellitic dianhydride, dimethylpyromellitic dianhydride, di(trifluoromethyl)-pyromellitic dianhydride, 3,3′,4,4′-biphenyltetracarboxylic dianhydride, 5,5′-dimethyl-3,3′,4,4′-biphenyltetracarboxylic dianhydride, p-(3,4-dicarboxyphenyl)-benzene, the main chains of polyimides having low thermal expansibility in particular which are useful in the invention are constituted of at least one of the following residues:

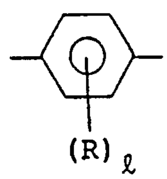 , 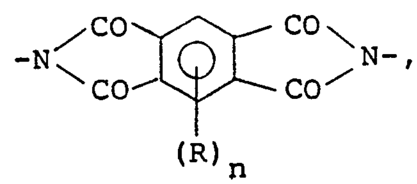 and

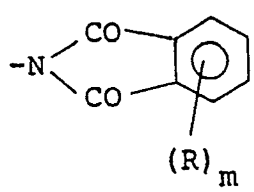

wherein, R is selected from the group consisting of alkyl, fluorinated alkyl, alkoxy, fluorinated alkoxy, acyl, and halogen, ℓ is an integer of 0 to 4, m is an integer of 0 to 3, and n is an integer of 0 to 2. More specifically, suitable residues for constituting such main chains are as follows:

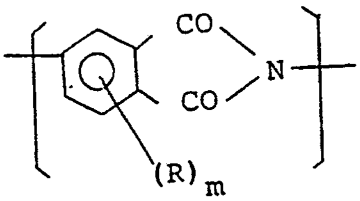

(1)

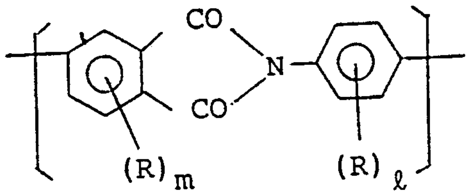

(2)

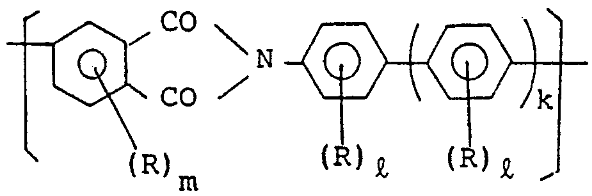

(3)

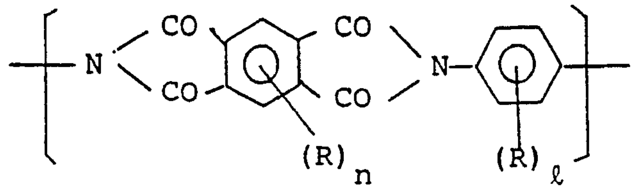

(4)

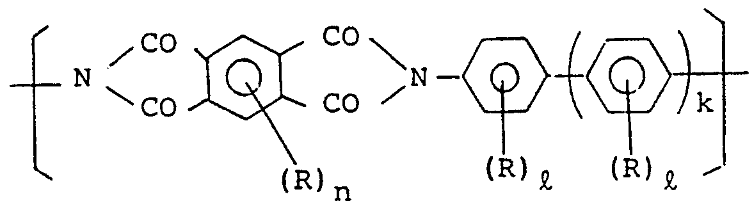

(5)

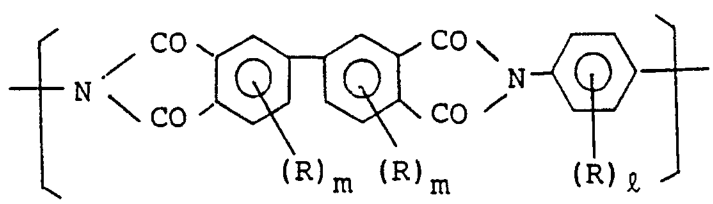

(6)

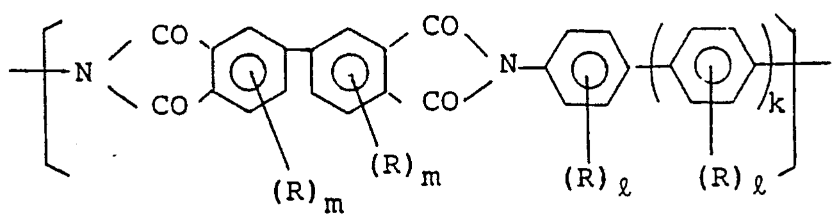

(7)

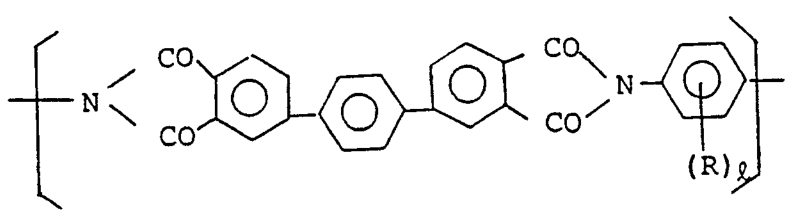

(8)

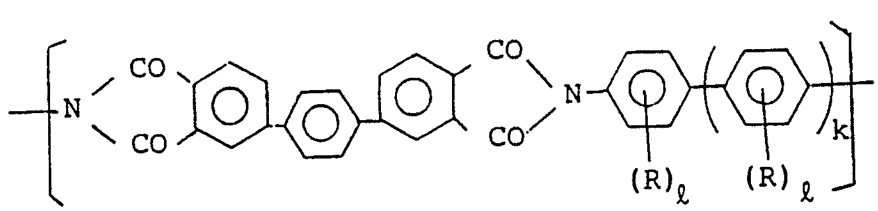

(9)

In these formulae, R is selected from the group consisting of alkyl, fluorinated alkyl, alkoxy, fluorinated alkoxy, acyl, and halogen, k is an integer of 0 to 3, $\ell$ is an integer of 0 to 4, m is an integer of 0 to 3, and n is an integer of 0 to 2.

Generally, polyimides are formed by coating polyamic acids, followed by thermal curing of the coats.

From common polyamic acids, however, it is impossible to obtain any polyimide having an aliphatic carboxy group(s) at one or both ends of the molecule. Therefore terminals of polyimide molecules need to by modified by some suitable method. However, polyimides are generally insoluble in any solvent and hence it is practically impossible to convert the terminal thereof into an aliphatic carboxy group by modification. The present inventors made intensive studies for the purpose of synthesizing a polyimide having an aliphatic carboxy group at one or both ends of the molecule. As a result, it has been revealed that the following compounds I and II are best suited for use to synthesize such a polyimide.

I:

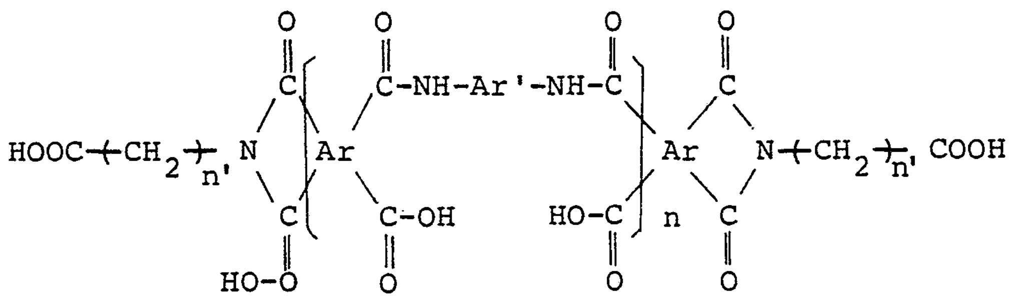

II:

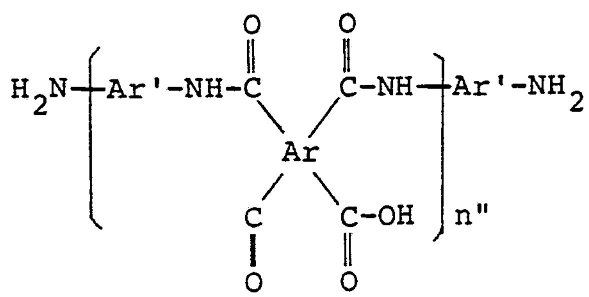

In these formulae, n and n″ are each an integer of 0 to 10, n′ is an integer of 2 to 12, and Ar and Ar′ denote aromatic residues.

Compounds I where n = 0 can be produced according to the method of J. Gagliani, K. Daniels, and P. straub, Preceedings of Second International Conference on Polyimides, 1 (1985). On the other hand, compounds I where n is at least 1 can be produced each by reacting an acid anhydride with a prescribed amount of lactum at a temperature of 180 to 200°C for a period of 10 to 30 hours, cooling the resulting reaction mixture to room temperature, and adding a prescribed amount of diamine.

It may noted that not both ends but one end of the compound 1 molecule needs to take imido structure, that is, one end may take acid anhydride structure.

In both compounds I and II, the number of repeating units is as small as from 0 to 10. Hence, a varnish prepared by dissolving compounds I and II has a much lower viscosity than that of the conventional polyamic acid varnish of the same concentration. This is consistent with the general rule of the viscosity of polymer in concentrated solution, that is, the viscosity is nearly proportional to the 6th power of the molecular weight of polymer. Accordingly, a highly concentrated varnish can be prepared by dissolving compounds I and II in a solvent. Thus, it becomes possible by using this varnish to produce electronic devices provided with insulating films superior in flatness. In addition, electronic device production processes wherein this varnish is used are advantageous industrially in that the volatilization and dissipation of solvent is limited. It has been revealed that when this varnish is heated, polymerization takes place, yielding finally a polyimide whose mechanical properties and heat resistance are equivalent to those of the polyimide produced from the conventional polyamic acid.

When the present varnish is used in the fabrication of electronic devices, a larger n′ of compound I is advantageous in that the longer $-(CH_2)_{n'}-$ group provided the higher solubility to compound I. However, as the $-(CH_2)_{n'}-$ chain length is increased, the diffusion of an aminocarboxylic acid formed

during the varnish curing becomes slower, causing an increase in the amount of aminocarboxylic acid remaining in the product polymer. This, having adverse effects on the heat resistance and mechanical properties of polyimide, should be avoided. Accordingly, preferred values of n′ are approximately from 2 to 8. When an acid dianhydride is reacted at only one end of the molecule with a lactum, the use of this reaction product is allowable if its solubility is sufficient. When one mole of an acid dianhydride is reacted with two moles or more of a lactum, an excess of the lactum reacts with the terminal groups of the dicarboxylic acid (compound I) to form amido bonds and extended molecular chains. The solubility of the resulting compound in polar solvents is sufficient, causing no difficulty, but the long molecular amide chain resulting from the exchange reaction in curing involves problems associated with the purity of the resulting polyimide. Considering the above, the molar ratio of the acid dianhydride to the lactum is preferred to be from about 1:1 to about 1:3.

The result of investigating various polyimides has revealed that polyimides from the following acid dianhydrides and aromatic diamines are particularly preferable.

Acid dianhydrides:

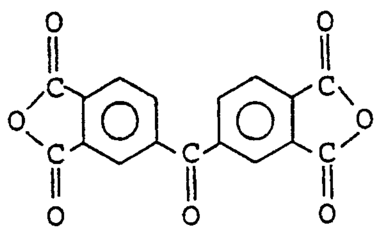 ,

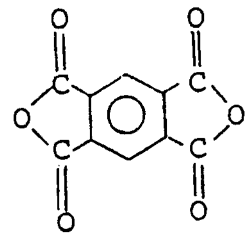 ,

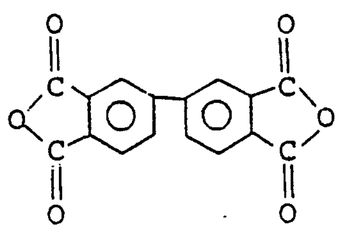 ,

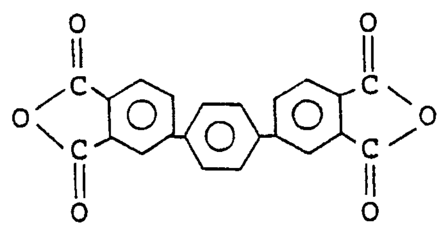 ,

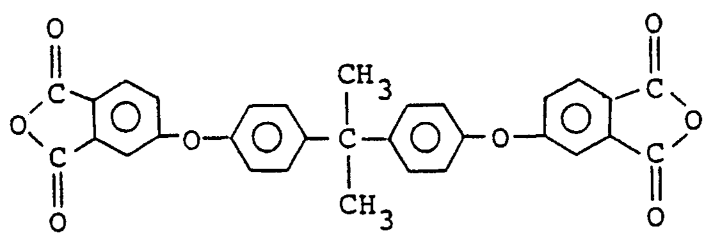

Aromatic diamines:

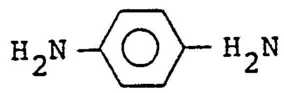 ,

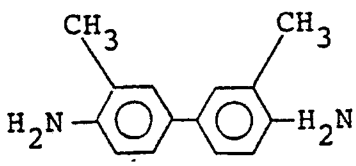 , 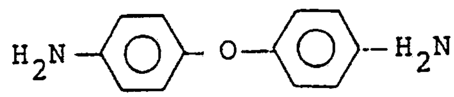

While the aromatic ring or methyl group of these acid dianhydrides or aromatic diamines has no substituent, modified polyimides having lower permittivity and/or lower hygroscopicity have been prepared from acid dianhydrides and aromatic diamines by introducing, into these starting compounds, alkyl, fluorinated alkyl, alkoxy, fluorinated alkoxy, or halogen.

Further, it is readily foreseeable that similarly-improved polyimides will be produced by copolymerization or compounding, for instance, a polyimide more improved in adhesive properties may be obtained by using an adhesion improver such as 1,3-bis(3,4-dicarboxy[1,2,2]bicyclo)tetramethyldisiloxane dianhydride.

It is known that polyimides having rod-like structure exhibit low thermal expansibility. Accordingly, electronic devices provided with insulating films which are superior in flatness and have low remaining thermal stress can be produced by using a present typical starting materials for producing such polyimides.

Acid anhydrides:

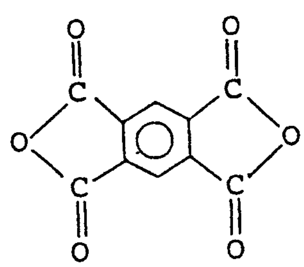 , 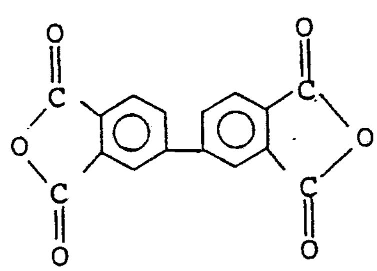

Aromatic diamines:

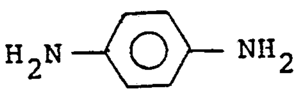 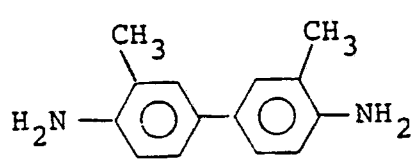

When a polyimide used herein has rigid rod-like structure, it is readily foreseeable that the polyimide will exhibit a low thermal expansibility. Since the low thermal expansibility results from the skeletal structure of the main chain, it is also obvious that the thermal expansibility can be further lowered by introducing alkyl, fluorinated alkyl, alkoxy, fluorinated alkoxy, acyl or halogen into the aromatic ring of the monomer(s). In addition, modifications are possible by copolymerizing other diamines or acid dianhydrides. For instance,

a flexible polyimide is produced by copolymerizing 3,3',4,4'-benzophenonetetracarboxylic acid or the like that can provide flexibility in such an amount as not to sacrifice the low thermal expansibility; the adhesive property can be more improved by copolymerizing an adhesion improver such as 1,3-bis(3,4-dicarboxy-[1,2,2]bicyclo)tetramethyldisiloxane dianhydride, as stated above; and the wet etching performance characteristic, which is important for LSI fabrication processes, can be controlled by copolymerizing pyromellitic dianhydride, the formula of which is given above, with 3,3',4,4'-biphenyltetracarboxylic dianhydride.

The present inventive polyimide, electronic devices and process for the production thereof are very useful for the following applications:

(1) Carrier film for IC or LSI
(2) Flat cable
(3) Flexible printed circuit board
(4) Insulating film for wirings in LSI
(5) Moisture-proof film for LSI
(6) $\alpha$-Ray shield film for LSI
(7) Film-insulated coil
(8) Passivation film on semiconductor
(9) Metal-core printed circuit board having insulating polyamide film.
(10) Solar battery
(11) Interlaminar insulating film in thin-film magnetic head
(12) Interlaminar insulating film in magnetic bubble memory

Coefficients of thermal expansion (linear coefficient of expansion) of almost all organic polymers are $4 \times 10^{-5}$ $K^{-1}$ and more even below their respective glass transition temperatures. There figures are much larger than those of metals and inorganic substances. There are a great number of problems attributable to the large linear coefficients of expansion of organic substances. It is not too much to say that reasons why the development of organic polymer applications does not advance as desired reside all in this respect. As an example, for use as flexible printed circuit substrates (FPC) that comprise each a film and a conductor, there is a need for composite films produced by coating or hot pressing a flexible-film forming material on metal foils. However, since the flexible-film forming material after coating must be cured, dried, or hot pressed at a high temperature, the hot composite film on cooling then to room temperature will curl on account of the thermal stress which results from the difference in the coefficient of thermal expansion between the flexible film and the metal foil. For the purpose of preventing this phenomenon, adhesives curable at low temperatures are commonly used to stick the two materials together. But, in the case of FPC required to have heat resistance, even a heat resistant film such as a polyimide film, when used for the base material, cannot exhibit its inherent heat resistance since low-temperature curable adhesives are generally inferior in heat resistance. Moreover, when an organic coating material is applied on a metal or inorganic plate that has a very small coefficient of thermal expansion as compared with those of common organic polymers, the composite film will deform or break or the coating will develop cracks or undergo peeling on account of the thermal stress resulting from the difference in the coefficient of thermal expansion. For instance, when a coating is formed on a silicon wafer for protecting LSI or IC, the wafer will warp, making it impossible to perform photolithography for patterning or lowering the resolution in the extreme, and the thermal stress when remarkable may cause the passivation film (protecting film) to peel off or the silicon wafer itself to cleave to destruction.

As noted above, numerous problems are raised by large linear coefficients of expansion of organic polymers. Therefore, an organic polymer having a small coefficient of thermal expansion has fairly-long been desired intensely. A polymer which can meet this requirement is PIQ-L100 of Hitachi Kasei Co., Ltd. PIQ-L100 is a varnish which, on heating or chemical treatment, provides a polyimide having a thermal expansion coefficient of about $1.0 \times 10^{-6}$ $deg^{-1}$, which is as small as those of inorganic substances. Thus, this varnish is an excellent material from the viewpoint of the relaxation of thermal stress in organic-inorganic composites. However, a problem of PIQ-L100 is that the flattening property is not taken into consideration. This is explained below taking an LSI multilayer circuit device as an example. In the fabrication of such a device, the interlaminar insulating film is made up in the following way: A polyimide coating 3-4 mμ thick is formed on a layer having a wiring level difference of about 1 um and flattened, and then a large part of the coating thickness is etched back by oxygen RIE (Reactive Ion Etching). However, the speed of etch back by the RIE is not necessary uniform throughout the whole area of the coating and the end point is different to detect. In addition, there are marked process problems such as the contamination of the reactor and product with matter resulting from the etching. Accordingly, the etching needs to be minimized. Hence, a resin superior in the flattening property is strongly desired. Moreover, when the number of superposed circuit layers is increased in the future, increase in the number of

operation steps will be a significant problem. Hence, there is stronger demand for a resin which has a superior flattening property and permits omitting the RIE process that is much time-consuming.

In the present invention, electronic devices, wherein thermal stress is reduced in the extreme, provided with flat insulating films which exhibit satisfactory-mechanical properties and heat resistance can be produced by using a varnish of low viscosity which contains low molecular compounds in high concentrations but, on heating provides a macromolecular imide resin exhibiting low thermal expansibility.

Currently, varnishes in various forms are used in numerous processes for producing electronic devices. These varnishes are used in low concentrations of some dozen %. In the production process, polyamic acids in varnish form are converted into polyimides by volatilizing the solvent and further heating or chemical treatment of the residue. When such a varnish of low concentration is used, a long time will be consumed for drying as written in Journal of Applied Polymer Science, 32, 4541-4552 (1986) and in addition more energy will be consumed. Another problem is the development of voids. The varnish of low concentration, as compared with a varnish having the same viscosity at a high concentration, loses fluidity in drying while the solvent remains in a larger amount. Thereby, the heat transfer and the diffusion of solvent vapor are depressed and at the same time a local shrinkage of the polymer is caused. This local shrinkage is the major factor of the void development. This void development has serious adverse effects on the product quality. When a varnish of low concentration is used it is obvious that a larger apparatus and a wider storage area are necessary in the factory. Also in this aspect, the use of a varnish of low concentration is undesirable. On the other hand, when the conventional varnish of high concentration is used, it is impossible, as stated already, to provide a resin having satisfactory properties.

[Action]

The electronic device of the present invention is provided with a homogeneous interlaminar insulating film which combines superior flatness and adhesive properties as well as excellent mechanical properties. Accordingly, the production process and the product have improved reliability and the product exhibits higher performance.

The present inventive process for producing electronic devices employs a low-viscosity varnish comprising high-concentrations of compounds I and II which have low molecular weights but, on heating, react with each other to form a macromolecular polyimide, thereby providing electronic devices having interlaminar insulating films which combine superior flatness and adhesive properties as well as excellent mechanical properties. According to the present process, the rationalization of facilities and the preservation of energy can also be achieved since the curing of the varnish requires the volatilization of less solvent.

[Examples]

Fig. 1 shows a cross section of the multilayer circuit portion of an LSI. In this drawing, 1 is a silicon wafer, 2 a thermally oxidized film, 3 an aluminum wiring, and 4 an insulating polyimide film of low thermal expansibility. This insulating film, when formed by spin coating, offsets largely the level difference due to the Al wiring, thus providing a flat and highly reliable wiring structure. In addition, thermal stress exerted on the device is minimized because of the low thermal expansibility of the insulating film. If the thermal stress is great, cracks will develop in the device.

The film of low thermal expansibility can be readily processed by using hydrazine or the like. The etching speed is about twice as high as in case of the conventional polyimide.

When the present inventive polyimide of low thermal expansibility is used for the insulating film in LSI shown in Fig. 1, the shrinkage under curing is inhibited by the silicon wafer and thus the insulating film exhibits low thermal expansibility.

Fig. 2 is a cross-sectional view of a magnetic bubble memory device. In this drawing, 5 is a substrate made of garnet, 6 a conductor, 7 an insulating polyimide film, and 8 a Permalloy member. When the insulating film is formed from the present inventive varnish by spin coating, the level difference due to the conductor can be offset to a great extent and transmission characteristics of the magnetic bubble device can be largely improved. The rise angle 9 also is much smaller than in the case of polyimides formed from conventional polyamic acids. When a present inventive polyimide of lower thermal expansibility is used, less thermal stress is exerted between the polyimide film and each of other inorganic materials.

Fig. 3 show a cross section of a thin-film magnetic head. In this drawing, 10 is an underlying alumina layer, 11 a lower magnetic member, 12 a gap alumina, 13 the first conductor coil, 14 an interlaminar insulating polyimide film, 15 the second conductor coil, and 16 an upper magnetic member. When the interlaminar insulating film is formed from the present inventive varnish by spin coating, the level differences due to the conductor coils can be offset to a great extent. conventionally, a flat-surfaced insulating film has been formed by thick coating, followed by etching back. The amount of insulating layer etched can be reduced to one half by forming the present invention polyimide. Thereby, the production process can be cut largely and the accuracy of film thickness can be improved.

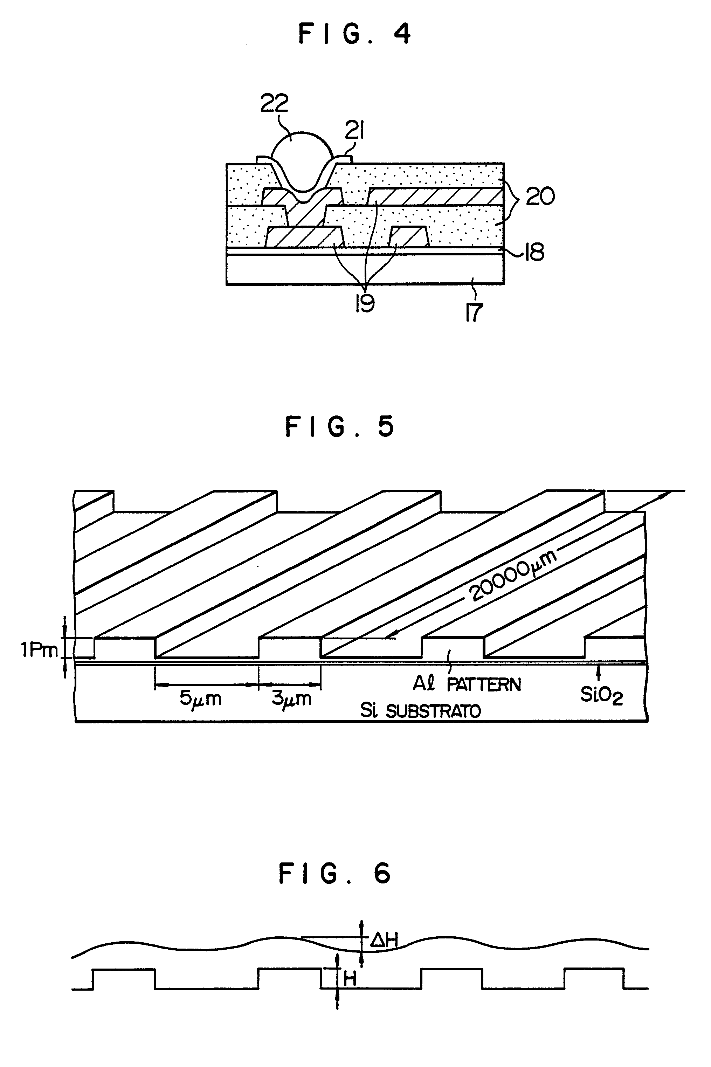

Fig. 4 shows a cross section of a high-density circuit board. In this drawing, 17 is a silicon wafer, 18 a thermally oxidized film, 19 a copper wiring, 20 an interlaminar insulating polyimide film, 21 a BLM (Burried Layered Metal), and 22 a Pb/Sm electrode. When the interlaminar insulating film is formed of the present inventive polyimide by spin coating, the level difference due to the copper wiring can be offset to a large extent and a flat, highly reliable wiring structure can be provided. When a present inventive polyimide of low thermal expansibility is used, thermal stress in the device can be reduced extremely.

Table 1 shows results of evaluating typical polyimides for flatness and mechanical and thermal properties, which are regarded as necessary characteristics to use in electronic devices.

Polyimide 1 was obtained from a varnish which was prepared by using 3,3′,4,4′-biphenyltetracarboxylic dianhydride:

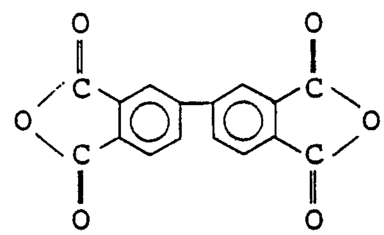

as acid dianhydride p-phenylenediamine:

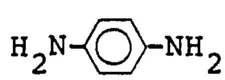

as diamine, and ε-caprolactum as lactum under such conditions that the value of n in compound I and the value of n″ of compound II might become 3 each. Further, in this case, ε-caprolactum was added in such an amount that just one molecule of ε-caprolactum might be added to each molecular terminal of compound 1. The concentration shown in Table is that of the varnish calculated without including the weight of γ-caprolactum in the solid content. While the solvent used in this case was n-methylpyrrolidone, other polar solvents may be used such as dimethylformamide, dimethylsulfoxide, dimethylacetamide, tetrahydrofuran, mixtures of these solvents, and mixtures of these solvent with other polar solvents.

Polyimide 2 was prepared in the same manner as for polyimide 1 but using 3,3′,4,4′-benzophenonetetracarboxylic dianhydride:

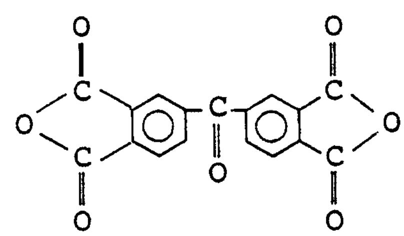

as acid dianhydride and 4,4′-diaminodiphenyl ether:

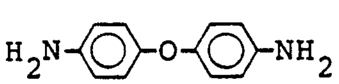

as diamine.

Polyimide 3 was prepared in the same manner as for polyimide 1 but using 3,3',4,4'-benzophenonetetracarboxylic dianhydride as acid dianhydride.

Polyimide 4 was prepared in the same manner as for polyimide 1 but using 2-pyrrolidone in place of ε-caprolactum

Polyimide 5 was prepared in the same manner as for polyimide 2 but using 2-pyrrolidone in place of ε-caprolactum.

Polyimide 6 was prepared in the same manner as for polyimide 3 but using 2-pyrrolidone in place of ε-caprolactum.

Polyimide 7 was prepared in the same manner as for polyimide 1 but using ω-octalactum in place of ε-caprolactum.

Polyimide 8 was prepared in the same manner as for polyimide 2 but using ω-octalactum in place of ε-caprolactum.

Polyimide 9 was prepared in the same manner as for polyimide 3 but using ω-octalactum in place of ε-caprolactum.

Polyimide 10 was prepared in the same manner as for polyimide 1 but under such conditions that the n of compound I and the n" of compound II might be 0 each.

Polyimide 11 was prepared in the same manner as for polyimide 2 but under such conditions that the n of compound I and the n" of compound II might be 0 each.

Polyimide 12 was prepared in the same manner as for polyimide 3 but under such condition that the n of compound I and the n" of compound II might be 0 each.

Polyimide 13 was prepared in the same manner as for polyimide 4 but under such conditions that the n of compound I and the n" of compound II might be 0 each.

Polyimide 14 was prepared in the same manner as for polyimide 7 but under such conditions that the n of compound I and the n" of compound 2 might be 0 each.

Polyimide 15 was prepared by the ester oligomer method as follows: Two oligomers terminated severally by acid anhydride groups and amine groups and consisting each of three repeating amic acid units were prepared from the same acid dianhydride and diamine, respectively, as used in the preparation of polyimide 1. The oligomer terminated by acid anhydride groups was half-esterified by reacting ethanol with the oligomer in a molar ratio of 2:1 to add ethanol to the ends of the oligomer molecules. Then, the half-esterified oligomer was mixed with the amino-terminated oligomer in an equimolar ratio.

Polyimide 16 was prepared in the above stated manner of preparing polyimide 15 by using 3,3',4,4' benzophenonetetracarboxylic dianhydride as acid dianhydride and 4,4'-diaminodiphenyl ester as diamine.

Polyimide 17 is an oligomer, terminated by ethynyl groups, having the following structure:

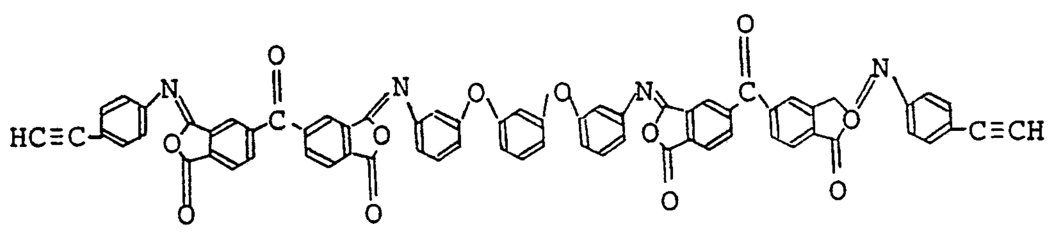

Polyimide 18 was prepared from a common polyamic acid varnish. The polyamic acid was prepared from the same acid dianhydride and diamine as used for the preparation of polyimide 1. Since the viscosity of this varnish increased during preparation thereof, the varnish was subjected to a viscosity-reducing heat treatment called "cooking".

Coefficients of thermal expansion of these polyimides were measured in the following way: A sample of the varnish was applied by an application to coat uniformly a glass plate. The coating was dried at a temperature of 80 to 100°C for a period of 30 to 60 minutes to form a film. This film was peeled from the glass plate fixed on an iron frame, and heated at 200, 300 and 400°C for 60 minutes each, giving a 30-200-µm thick polyimide film. A piece (3 mm × 80 mm) was cut off from this polyimide film, interposed between two glass plates, then heated again to 500°C, and cooled gradually to remove residual strain. The dimensional change of this film with temperature below the glass transition point was measured by using. Thermal Mechanical Analizer at a heating rate of 5°C/min. The coefficient of thermal expansion of polyimides will not accurately be measurable unless such treatments as stated above are performed to remove thoroughly the absorbed mixture and solvent and the residual strain, the strain being originated

from the imide forming reaction, from the film and complete substantially the imide forming reaction. When moisture is absorbed by the film the coefficient of the thermal expansion in the range of from room temperature to 150°C is apparently smaller than the true value on account of the dehydration. When strain remains in the film or the imide forming reaction is not completed, the film shrinkage is caused by release of the residual strain around the glass transition temperature or by the dehydration due to the imide forming reaction and therefore the apparent coefficient of the thermal expansion is often observed to be smaller. It must be kept in mind that when the film is fixed on an iron frame but it breaks in the course of curing, the orientation treatment will be insufficient and hence the coefficient of the thermal expansion will be somewhat larger.

The flatness was evaluated by using test substrates prepared each by forming an aluminum pattern as shown in Fig. 5 on a silicon base plate. That is, a sample varnish was applied on this test substrate by spin coating and cured under the same conditions as used in the above stated preparation of thermal expansion test specimens, thereby preparing a flatness test specimen having a predetermined thickness. The revolution of the spinner coater was varied from 1000 to 8000 rpm depending on the necessary film thickness. The flatness of the test specimen was measured by using a needle contact type of surface roughness tester (α-Step 200, supplied by Tencar Instruments Co.) "Degree of flatness P" in Table 1 is defined by the following formula and the value of P shown are of the surface of a 2-μm thick film formed on the above-mentioned test substrate.

$$P = \frac{\Delta H}{H}$$

wherein H and ΔH are as shown in Fig. 6.

The heat resistance is represented by the temperature at which heating of the sampler for 100 minutes resulted in 3% loss in the weight of the sample.

The tensile strength was measured of the same test specimens as prepared in the measurement of the coefficient of thermal expansion, at room temperature by using a Thamal Mechanical Analizer.

Table 2 shows results of testing for adhesive properties of typical polyimides.

Polyimides 19 and 20 were obtained similarly to polyimide 18 from polyamic acids which were prepared from the same acid dianhydride and the same respective diamines as used for the preparation of polyimides 2 and 3.

The sample tested for adhesive properties was prepared by forming a thermally oxidized film on a silicon substrate, treating the oxidized film with an aluminum chelate, applying a given varnish on the treated surface by spin coating, curing the varnish coat at 350°C to form the first polyimide layer, coarsening the surface of this polyimide layer by using an oxygen plasma etcher, applying further the same varnish on the coarsened surface by spin coating, and curing this varnish coat to form the polyimide layer. The thermally oxidized film treated with the aluminum chelate exhibits sufficiently-high adhesion to the polyimide, that is, this adhesion is not important. Therefore, tests were made for the adhesion between the first and second polyimide layers.

The peel strength was measured in the following mannaer: A rectangular piece 10 mm wide and 20 mm long was cut off from the test sample. The rear wall of the silicon substrate of the piece was scored in the width direction at the longitudinally central position. Then, the silicon substrate was cut into two along the score line so as not to break or hurt the polyimide layer. This test piece was subjected to a pressure cooker test (PCT, wherein the specimen is left standing in steam of 2 atm and 120°C) for a predetermined time. Then, one side of the piece was fixed on a cylindrical table and the other side on a phosphor bronze plate (0.1 mm thick) with an adhesive, and the peel strength was measured by using a universal tension tester at a draw speed of 0.5 mm/min.

Table 1

| Example | Poly-imide | Concent-ration (wt% of solids) | Degree of flatness, P [-] | Coefficient of thermal expansion ($10^{-5}$ $deg^{-1}$) | Heat resistance (°C) | Tensil strength (kgf/mm²) | Remarks |
|---|---|---|---|---|---|---|---|
| Example 1 | 1 | 35 | 0.79 | 0.9 | 517 | 46.0 | |
| " 2 | 2 | 36 | 0.80 | 4.3 | 475 | 17.5 | |
| " 3 | 3 | 36 | 0.80 | 2.4 | 483 | 20.3 | |
| " 4 | 4 | 40 | 0.83 | 0.8 | 520 | 47.0 | |
| " 5 | 5 | 38 | 0.82 | 4.4 | 476 | 18.5 | |
| " 6 | 6 | 42 | 0.84 | 2.3 | 485 | 20.0 | |
| " 7 | 7 | 35 | 0.79 | 1.0 | 515 | 45.7 | |
| " 8 | 8 | 35 | 0.78 | 4.2 | 475 | 17.0 | |
| " 9 | 9 | 34 | 0.78 | 2.4 | 480 | 20.0 | |
| " 10 | 10 | 35 | 0.78 | 1.0 | 515 | 43.0 | |
| " 11 | 11 | 35 | 0.80 | 4.3 | 470 ± | 18.0 | |
| " 12 | 12 | 34 | 0.79 | 2.2 | 481 | 19.3 | |
| " 13 | 13 | 38 | 0.81 | 0.9 | 513 | 44.3 | |

- Cont'd -

Table 1 (Cont'd)

| | | | | | | | |
|---|---|---|---|---|---|---|---|
| Example 14 | 14 | 33 | 0.77 | 1.0 | 510 | 43.8 | |
| Compar. Example 1 | 15 | 34 | 0.77 | - | 510 | - | Brittle |
| " 2 | 16 | 35 | 0.77 | - | 470 | - | " |
| " 3 | 17 | 36 | 0.79 | 4.5 | 390 | 13.5 | |
| " 4 | 18 | 15 | 0.40 | 0.8 | 516 | 45.0 | |

Table 2

| | Polyimide | Initial peel strength (g/cm) | Peel strength after PCT |
|---|---|---|---|
| Example 15 | 1 | 310 | 280 |
| Example 16 | 2 | 330 | 310 |
| Example 17 | 3 | 310 | 300 |
| Example 18 | 4 | 300 | 290 |
| Example 19 | 5 | 320 | 320 |
| Example 20 | 7 | 310 | 305 |
| Example 21 | 12 | 315 | 315 |
| Example 22 | 13 | 340 | 310 |
| Compar. Example 5 | 18 | 300 | Peeled off |
| Compar. Example 6 | 19 | 310 | Peeled off |
| Compar. Example 7 | 20 | 290 | Peeled off |

As illustrated in the above examples, the present inventive varnish provides a polyimide resin having flattening effect of twice or more that of the conventional resin. In addition, the present varnish, when

prepared from particularly selected monomers, provides a resin having a thermal expansion coefficient of 2 $\times 10^{-5}$/deg or less, which is exceptionally small as the value of an organic substance, and superior mechanical properties. Moreover, various process merits, e.g. reduction in the size of production facilities are attainably by using high concentrations of a varnish of the invention.

[Effects of the Invention]

The electronic device of the present invention has at least one homogeneous interlaminar insulating film which is improved in flatness and adhesive properties without imparing the heat resistance, mechanical properties, etc of the conventional film. Therefore, it is possible according to the invention to improve electronic devices in reliability and performance.

According to the invention, there is also provided a process for producing electronic devices having homogeneous interlaminar insulating films which are improved in flatness and adhesive properties without imparing the heat resistance, mechanical properties, etc. of the conventional film, and in addition, the rationalization of production processes is possible.

## Claims

1. An electronic device having a polyimide layer which is in direct or indirect contact with at least one active area of the electronic device, wherein the main chain of polyimide is constituted of all or some of the residues:

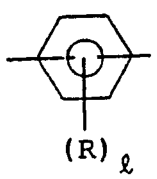 , 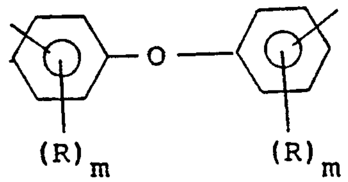 , 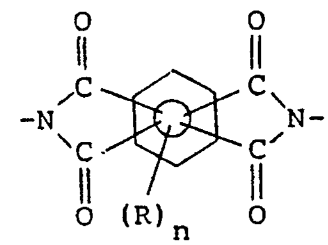 ,

, 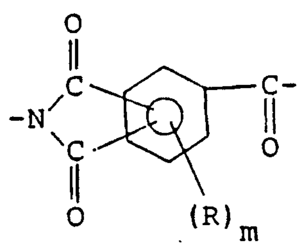

wherein, R is selected from the group consisting of alkyl, fluorinated alkyl, alkoxy, fluorinated alkoxy, acyl, and halogen, ℓ is an integer of 0 to 4, m is an integer of 0 to 3, and n is an integer of 0 to 2, and the polyimide has, at one end of the molecule, a carboxy group attached to an aliphatic carbon atom.

2. An electronic device having an insulating layer formed of a polyimide between conductors or between semiconductors, wherein the main chain of the polyimide is constituted of all or some of the residues:

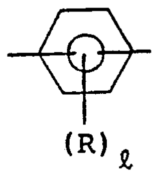 , 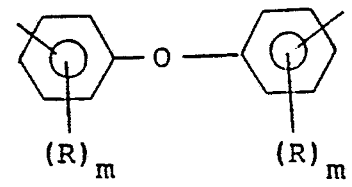 , 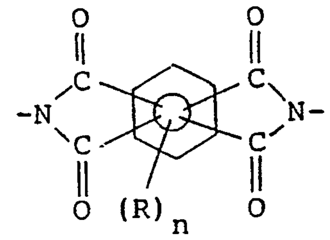 ,

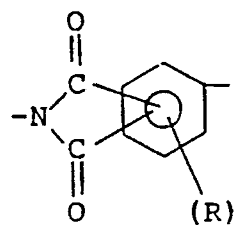 , 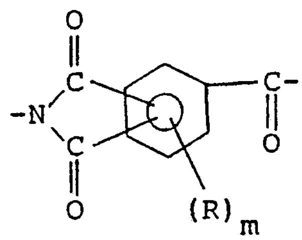

wherein, R is selected from the group consisting of alkyl, fluorinated alkyl, alkoxy, fluorinated alkoxy, acyl, and halogen, ℓ is an integer of 0 to 4, m is an integer of 0 to 3, and n is an integer of 0 to 2, and the polyimide has, at one end of the molecule, a carboxy group attached to an aliphatic carbon atom.

3. The electronic device of Claim 2, wherein the insulating layer is formed between a silicon wafer and a wiring or between wirings.

4. A thin-film magnetic head having an insulating layer between a substrate and a wiring or between wirings, wherein the insulating layer is a polyimide layer, the main chain of the polyimide is constituted of all or some of the residues:

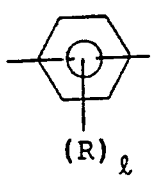 , 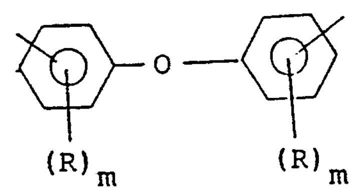 , 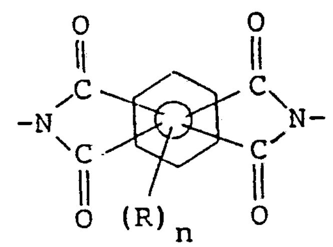 ,

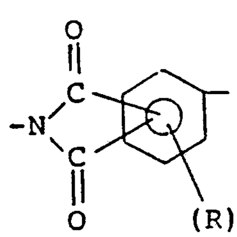 , 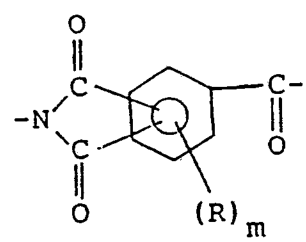

wherein, R is selected from the group consisting of alkyl, fluorinated alkyl, alkoxy, fluorinated alkoxy, acyl, and halogen, ℓ is an integer of 0 to 4, m is an integer of 0 to 3, and n is an integer of 0 to 2, and the polyimide has at one end of the molecule a carboxy group attached to an aliphatic carbon atom.

5. A high-density circuit board having an insulating layer between a substrate and a wiring or between wirings, wherein the insulating layer is a polyimide layer, the main chain of the polyimide is constituted of all or some of the residues:

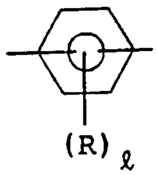 , 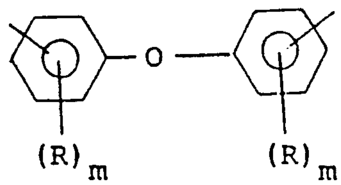 , 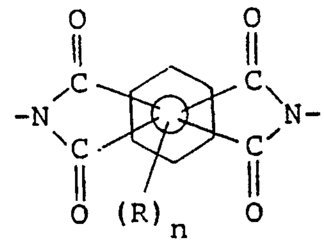 ,

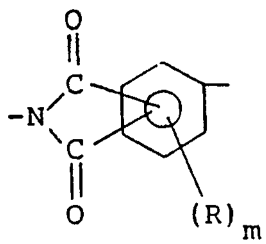 , 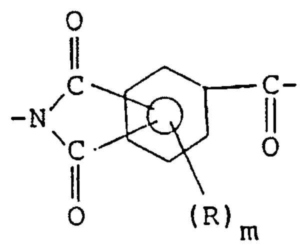

wherein, R is selected from the group consisting of alkyl, fluorinated alkyl, alkoxy, fluorinated alkoxy, acyl, and halogen, ℓ is an integer of 0 to 4, m is an integer of 0 to 3, and n is an integer of 0 to 2, and the polyimide has, at one end of the molecule, a carboxy group attached to an aliphatic carbon atom.

6. A magnetic bubble memory having an insulating layer between a substrate and a wiring or between wirings, wherein the insulating layer is a polyimide layer, the main chain of the polyimide is constituted of all or some of the residues:

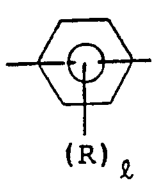 , 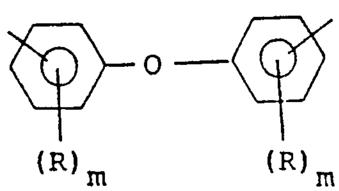 , 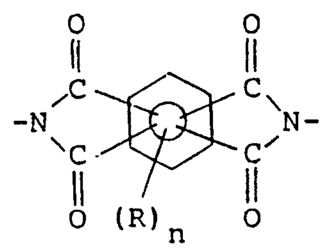 ,

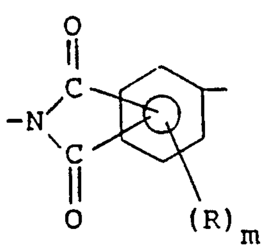 , 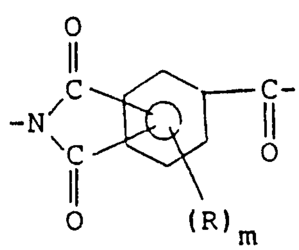

wherein, R is selected from the group consisting of alkyl, fluorinated alkyl, alkoxy, fluorinated alkoxy, acyl, and halogen, ℓ is an integer of 0 to 4, m is an integer of 0 to 3, and n is an integer of 0 to 2, and the polyimide has, at one end of the molecule, a carboxy group attached to an aliphatic carbon atom.

7. A magnetic disk having a magnetic recording medium comprising a magnetic substance-containing insulating layer formed on a nonmagnetic substrate, wherein the insulating layer is a polyimide layer, the main chain of the polyimide is constituted of all or some of the residues:

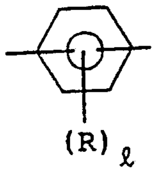 , 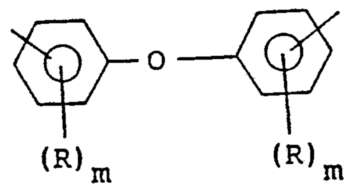 , 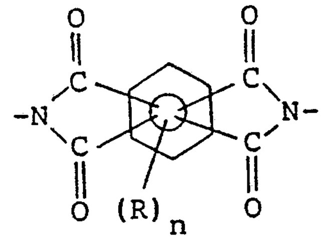 ,

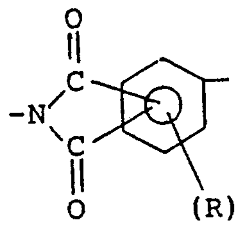 , 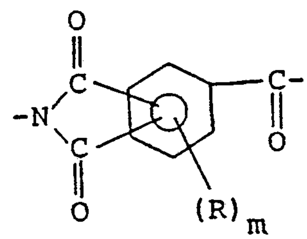

wherein, R is selected from the group consisting of alkyl, fluorinated alkyl, alkoxy, fluorinated alkoxy, acyl, and halogen, ℓ is an integer of 0 to 4, m is an integer of 0 to 3, and n is an integer of 0 to 2, and the polyimide has, at one end of the molecule, a carboxy group attached to an aliphatic carbon atom.

8. A solar battery comprising a substrate coated with an insulating layer, wherein the insulating layer is a polyimide layer, the main chain of the polyimide is constituted of all or some of the residues:

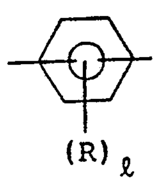 , 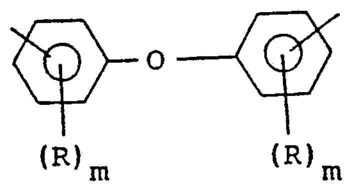 , 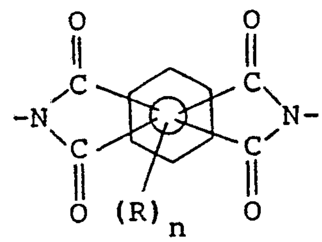 ,

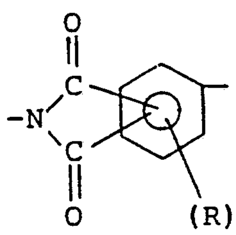 , 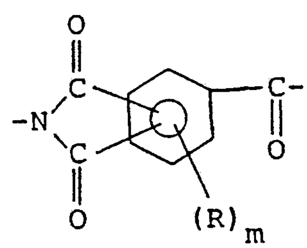

wherein, R is selected from the group consisting of alkyl, fluorinated alkyl, alkoxy, fluorinated alkoxy, acyl, and halogen, ℓ is an integer of 0 to 4, m is an integer of 0 to 3, and n is an integer of 0 to 2, and the polyimide has, at one end of the molecule, a carboxy group attached to an aliphatic carbon atom.

9. A memory device having an insulating layer as an α-ray shield film between conductors or between semiconductors, wherein the insulating layer is a polyimide layer, the main chain of the polyimide is constituted of all or some of the residues:

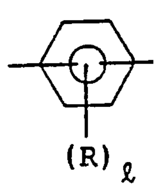 , 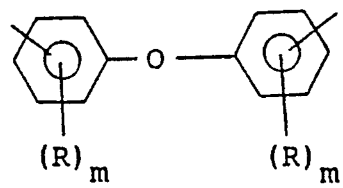 , 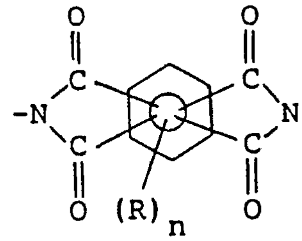 ,

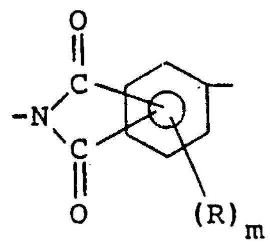 , 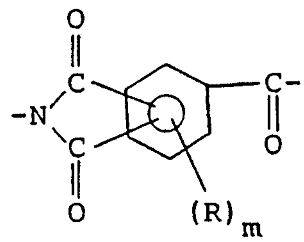

wherein, R is selected from the group consisting of alkyl, fluorinated alkyl, alkoxy, fluorinated alkoxy, acyl, and halogen, ℓ is an integer of 0 to 4, m is an integer of 0 to 3, and n is an integer of 0 to 2, and the polyimide has, at one end of the molecule, a carboxy group attached to an aliphatic carbon atom.

10. An electronic device having a polyimide film which is in direct or indirect contact with at least one active area of the electronic device, wherein the polyimide film is produced by reacting the following compounds I and II:

I:

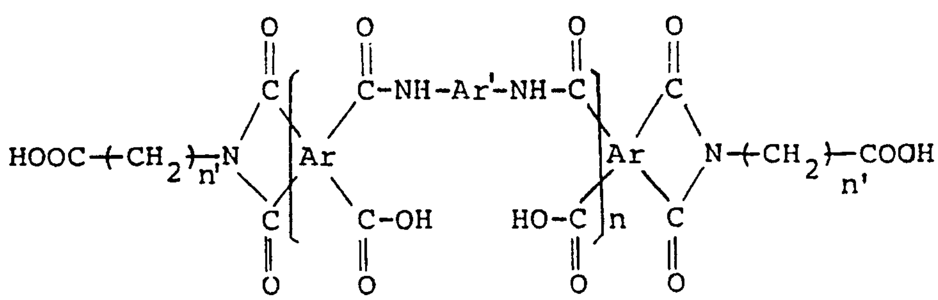

II:

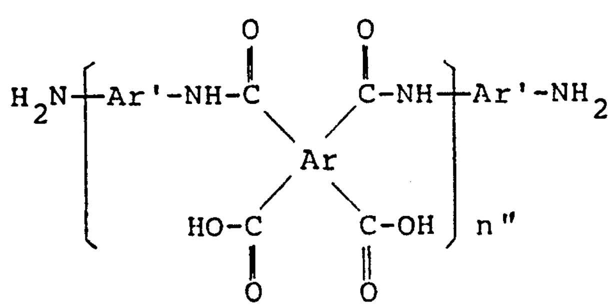

with each other, where the n of compound I and the n" of compound II are each an integer of 0 to 10, the n' of compound I is an integer of 2 to 12, and Ar and Ar' are aromatic residues with the proviso that one end of the compound I molecule need not take imido structure and may take acid anhydride structure.

11. The electronic device of Claim 10, wherein the Ar of compounds I and II is selected from the aromatic residues:

III: 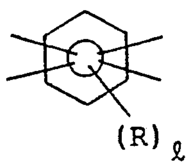 , IV: 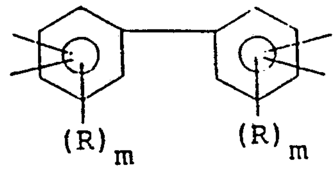 ,

V: 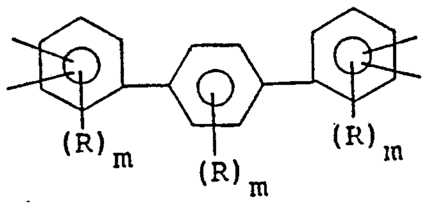 , VI: 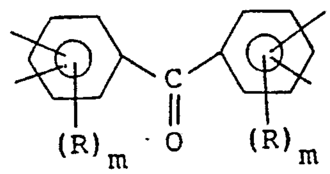 ,

and the Ar' of compounds I and II is selected from the aromatic residues:

VII: 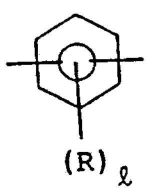 , VIII: 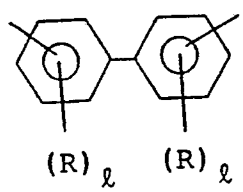 , IX: 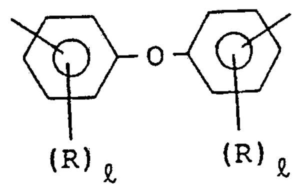

where, in residues III, IV, V, VI, VII, VIII, and IX, R is selected from the group consisting of alkyl, fluorinated alkyl, alkoxy, fluorinated alkoxy, acyl and halogen, ℓ is an integer of 0 to 2 in residue III and an integer of 0 to 4 in residues VII, VIII, and IX, and m is an integer of 0 to 3.

12. A process for producing an electronic device having a polyimide film which is in direct or indirect contact with at least one active area of the electronic device, wherein the polyimide film is produced by reacting the following compounds I and II:

I:

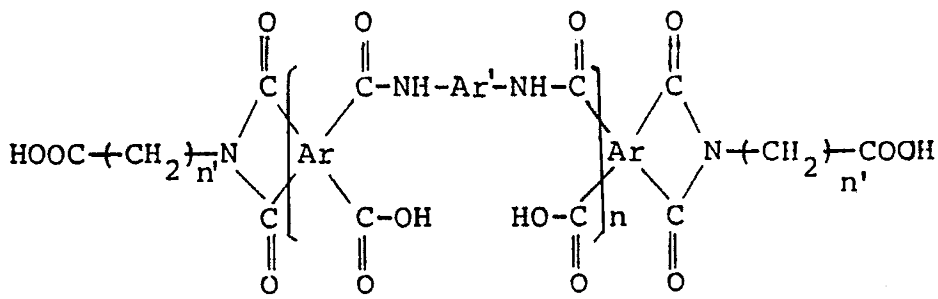

II:

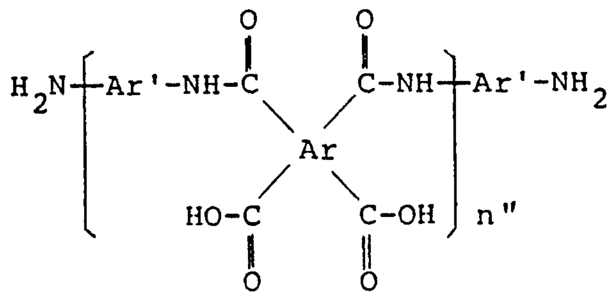

with each other, where the n of compound I and the n″ of compound II are each an integer of 0 to 10, the n′ compound I is an integer of 2 to 12, and Ar and Ar′ are aromatic residues with the proviso that one end of the compound I molecule need not take imido structure and may take acid anhydride structure.

13. The process of Claim 12, wherein the Ar of compounds I and II is selected from the aromatic residues:

III: 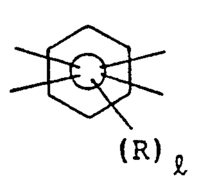 , IV: 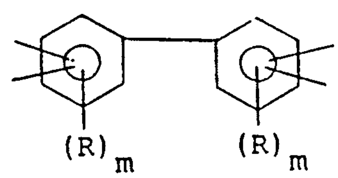 ,

V: 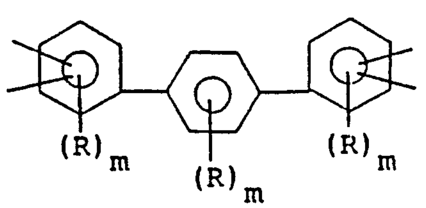 , VI: 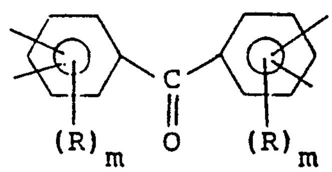 ,

and the Ar′ of compounds I and II is selected from the aromatic residues:

VII:

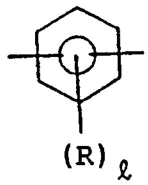

,

VIII:

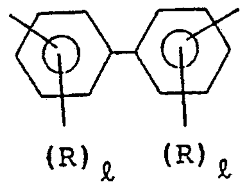

,

IX:

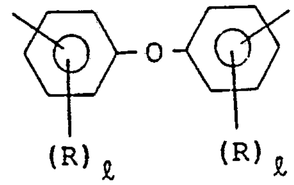

where, in residues III, IV, V, VI, VII, VIII, and IX, R is selected from the group consisting of alkyl, fluorinated alkyl, alkoxy, fluorinated alkoxy, acyl, and halogen, $\ell$ is an integer of 0 to 2 in residue III and an integer of 0 to 4 in residues VII, VIII, and IX, and m is an integer of 0 to 3.

FIG. 1

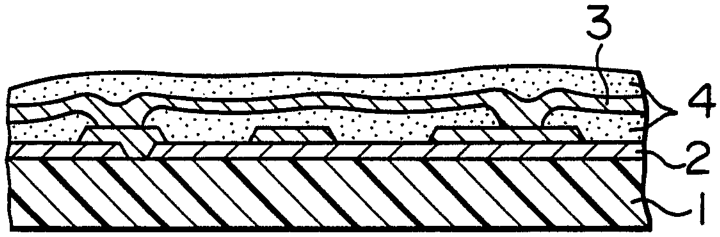


FIG. 2

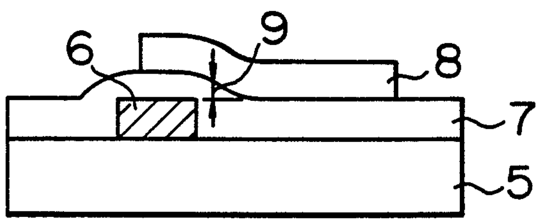


FIG. 3

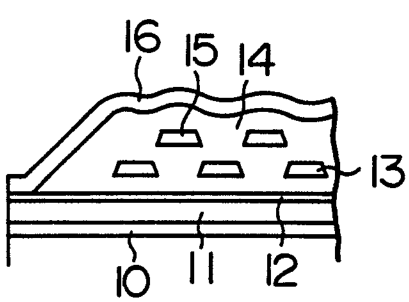

FIG. 4

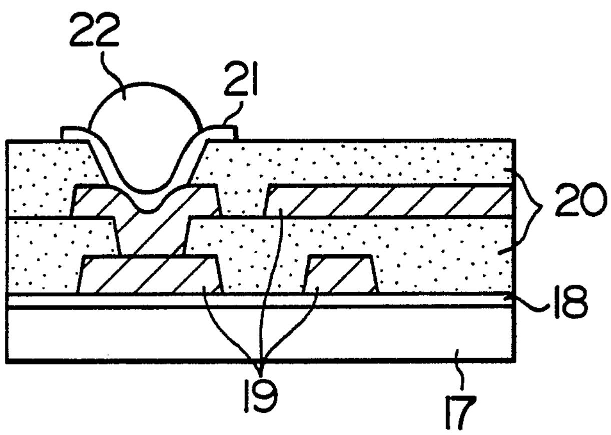


FIG. 5

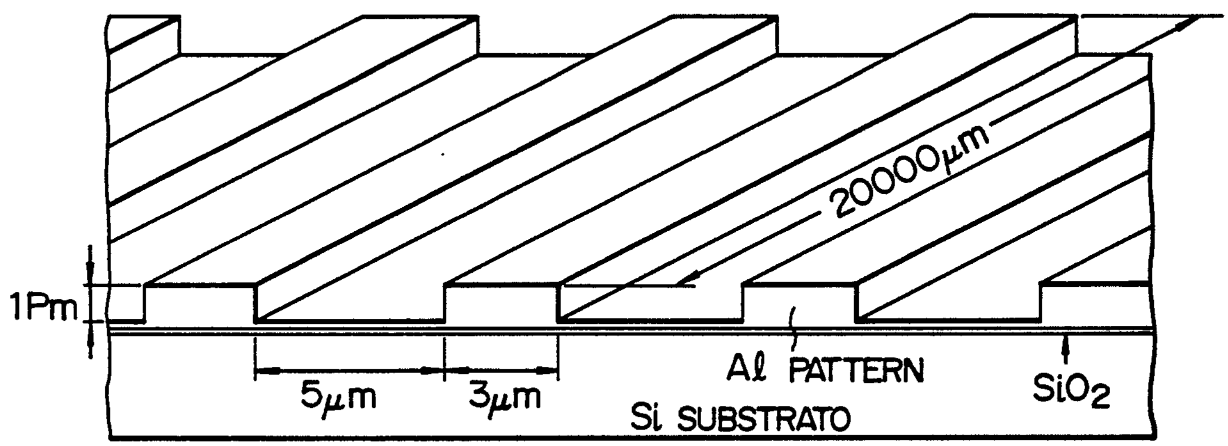


FIG. 6